(19) **Europäisches Patentamt European Patent Office Office européen des brevets**

(11) **EP 2 770 636 B1**

(12) **FASCICULE DE BREVET EUROPÉEN**

(45) Date de publication et mention de la délivrance du brevet:
**21.08.2019 Bulletin 2019/34**

(51) Int Cl.:
*H03K 17/10* *(2006.01)*     *H03K 17/74* *(2006.01)*

(21) Numéro de dépôt: **14152237.5**

(22) Date de dépôt: **23.01.2014**

(54) **Dispositif de commande employé dans un système d'alimentation à découpage**

**Steuervorrichtung, die in einem Stromzuführungssystem mit Partitionierung verwendet wird**

**Control device employed in a switched electrical power supply syetem**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.02.2013 FR 1351622**

(43) Date de publication de la demande:
**27.08.2014 Bulletin 2014/35**

(73) Titulaire: **Schneider Toshiba Inverter Europe SAS 27120 Pacy sur Eure (FR)**

(72) Inventeurs:
• **Barauna, Allan Pierre 27200 Vernon (FR)**
• **Boulharts, Hocine 78510 Triel sur Seine (FR)**

(74) Mandataire: **Dufresne, Thierry et al Schneider Electric Industries SAS Service Propriété Industrielle 35 rue Joseph Monier - CS 30323 92506 Rueil-Malmaison Cedex (FR)**

(56) Documents cités:
**EP-A2- 0 140 349      EP-A2- 0 453 376 US-A1- 2011 261 594**

• **HERBERT L HESS ET AL: "Transformerless Capacitive Coupling of Gate Signals for Series Operation of Power MOS Devices", IEEE TRANSACTIONS ON POWER ELECTRONICS, IEEE SERVICE CENTER, PISCATAWAY, NJ, US, vol. 15, no. 5, 1 septembre 2000 (2000-09-01), XP011043472, ISSN: 0885-8993**

## Description

## Domaine technique de l'invention

La présente invention se rapporte à un dispositif de commande employé dans un système d'alimentation électrique à découpage.

## Etat de la technique

Un système d'alimentation électrique à découpage (appelé également SMPS pour "Switched Mode Power Supply") permet de délivrer en sortie une ou plusieurs tensions continues à partir d'une tension continue prélevée en entrée. Ce type de système d'alimentation électrique à découpage est notamment employé dans un variateur de vitesse. Dans un variateur de vitesse, le système d'alimentation électrique à découpage est alors chargé de fournir une tension continue auxiliaire permettant d'alimenter toute l'électronique du variateur de vitesse, à partir d'une tension continue principale prélevée sur le bus continu d'alimentation du variateur de vitesse.

Le bus continu d'alimentation fournit une tension continue principale pouvant aller de 350 Vcc à plus de 1000 Vcc. Le dispositif de commande employé dans le système d'alimentation électrique à découpage doit ainsi pouvoir commuter un courant allant jusqu'à 2A sous 1700 Vcc. De manière connue, le dispositif de commande peut comporter un seul transistor de type MOSFET ayant une tension de claquage comprise entre 1200 V et 1700V. Cependant, à ces tensions de claquage, le transistor MOSFET est à ses limites technologiques. De plus, son coût est élevé et, en fonctionnement, ses pertes par effet joule sont particulièrement élevées.

Pour pallier ces inconvénients, il est connu d'associer deux transistors MOSFET en série, ayant des tensions de claquage plus faibles, allant de 600V à 900V. Chacun des deux transistors en série supporte ainsi une tension électrique moindre, compatible avec un emploi optimal de la technologie des MOSFET.

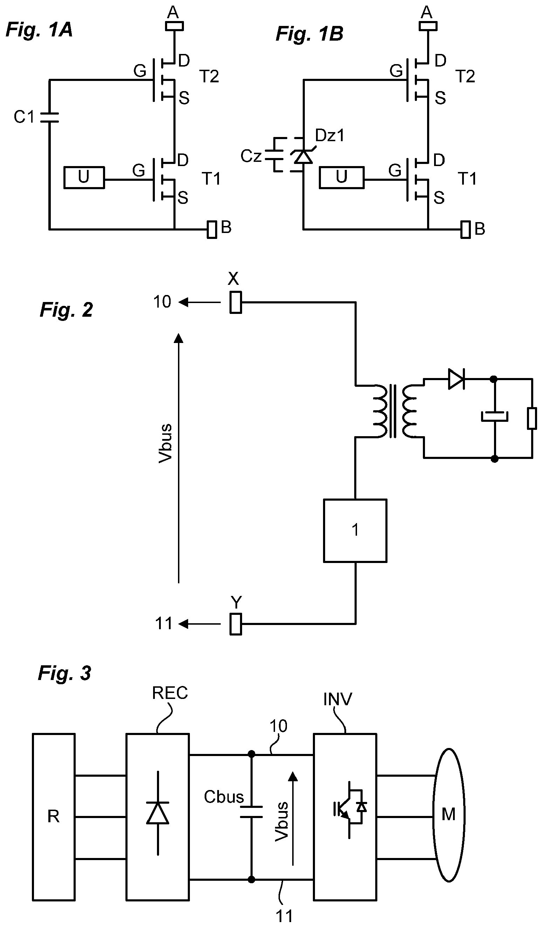

Dans l'état de la technique, plusieurs montages à deux transistors en série ont été proposés. La publication intitulée "Transformerless Capacitive Coupling of Gate Signals for Series Operation of Power MOS Devices" - Robert L. Hess et Russel Jacob Baker- IEEE transactions on power electronics, Vol. 15, N°5, Septembre 2000, décrit un dispositif de commande comportant au moins deux transistors de type MOSFET en série. Cette topologie est représentée sur la figure 1A. Dans cette topologie, le dispositif de commande comporte deux bornes d'entrée A, B et un premier transistor T1 connecté à la deuxième borne d'entrée B et recevant sur sa grille des signaux de commande provenant d'une unité de commande U. Un deuxième transistor T2 est connecté en série avec le premier transistor T1 et à la première borne d'entrée A. Un condensateur C1 est connecté entre la grille du deuxième transistor T2 et la première borne d'entrée A. Le rôle du condensateur C1 est double :

fournir assez de charge pour contrôler le deuxième transistor et limiter la tension aux bornes du premier transistor à une valeur optimale.

Pour ne pas être tributaire de ces deux conditions, il a notamment été proposé de remplacer le condensateur par une diode zener Dz1, qui permet alors de fixer la tension aux bornes du premier transistor T1. Cette deuxième topologie connue est représentée sur la figure 1B. Dans ce montage, le contrôle du deuxième transistor T2 est alors assuré grâce à la charge emmagasinée par la capacité parasite (Cz) de la diode zener Dz1. Cependant, si la charge transmise par la capacité parasite de la diode zener Dz1 est inférieure (due par exemple à une tension du bus continue trop faible) à la charge nécessaire à contrôler correctement le deuxième transistor T2, il est alors nécessaire d'ajouter un condensateur en parallèle de cette diode zener pour assurer un contrôle adapté du deuxième transistor. En ajoutant le condensateur en parallèle de la diode zener, les inconvénients identifiés pour le premier montage refont leur apparition.

Dans ces deux montages, le contrôle du deuxième transistor T2 dépend de la capacité du condensateur, intrinsèque ou additionnel, et du niveau de la tension aux bornes du condensateur. Pour contrôler de manière adaptée le deuxième transistor T2, à partir d'une tension qui est basse aux bornes du condensateur (intrinsèque à la diode zener Dz1 ou additionnel), il est nécessaire d'augmenter la capacité du condensateur connecté en série à la grille G du transistor T2. Or la capacité du condensateur ne peut pas être augmentée indéfiniment.

Différentes solutions de commande ont été décrites dans les demandes de brevet EP0453376A2, EP0140349A2 et US2011/0261594 A1 ainsi que dans la publication HERBERT L HESS intitulée "Transformerless Capacitive coupling of Gate Signals for Series Operation of Power MOS Devices" du 01 septembre 2000 - XP011043472.

Le but de l'invention est de proposer un dispositif de commande à deux transistors en série, destiné à être employé dans un système d'alimentation électrique à découpage, le dispositif de commande permettant un contrôle adapté du deuxième transistor quel que soit le niveau de la tension continue principale, et sans augmenter la capacité d'un condensateur.

## Exposé de l'invention

Ce but est atteint par un dispositif de commande selon la revendication 1.

Selon une particularité, le dispositif comporte un ou plusieurs motifs identiques superposés, chaque motif comprenant :

- deux points de connexion,
- un condensateur connecté à un premier point de connexion,
- une première diode zener connectée en série avec ledit condensateur,

- un troisième transistor doté d'une grille connectée audit condensateur et d'une source connectée à un deuxième point de connexion,

- une troisième diode zener connectée entre la grille et la source du troisième transistor,

- le premier motif ajouté venant se connecter par son deuxième point de connexion sur le drain du deuxième transistor et par son premier point de connexion sur la grille du deuxième transistor,

- chaque motif supplémentaire venant se connecter par son deuxième point de connexion sur le drain du transistor du motif précédent et par son premier point de connexion sur la grille du transistor du motif précédent.

L'invention concerne également un système d'alimentation électrique à découpage comprenant une première borne et une deuxième borne entre lesquelles est connectée une source de tension continue, un convertisseur continu/continu connecté à la première borne et un dispositif de commande connecté en série avec le convertisseur continu/continu et à la deuxième borne, ledit dispositif de commande étant conforme à celui défini ci-dessus.

Selon une particularité, le convertisseur continu/continu est de type "flyback" isolé, de type "forward" isolé, de type élévateur ou de type abaisseur.

L'invention concerne enfin un variateur de vitesse destiné à commander une charge électrique, ledit variateur comportant :

- un module redresseur destiné à redresser une tension alternative fournie par un réseau de distribution électrique,

- un bus continu d'alimentation connecté au module redresseur et comportant une première ligne d'alimentation à potentiel électrique positif et une deuxième ligne d'alimentation à potentiel électrique négatif entre lesquelles est appliquée une tension continue principale fournie par le module redresseur,

- un condensateur de bus connecté à la première ligne d'alimentation et à la deuxième ligne d'alimentation,

- un module onduleur comportant plusieurs transistors de commutation destinés à convertir la tension continue disponible sur le bus en une tension variable à destination de la charge électrique,

- un système d'alimentation électrique à découpage conforme à celui défini ci-dessus, la première borne du système d'alimentation électrique à découpage étant connectée à la première ligne d'alimentation du bus continu d'alimentation et la deuxième borne du système d'alimentation électrique à découpage étant connectée à la deuxième ligne d'alimentation du bus continu d'alimentation.

**Brève description des figures**

D'autres caractéristiques et avantages vont apparaître dans la description détaillée qui suit faite en regard des dessins annexés qui représentent :

- la figure 1A représente un dispositif de commande à deux transistors en série, selon un premier état de la technique,

- la figure 1B représente un dispositif de commande à deux transistors en série, selon un deuxième état de la technique,

- la figure 2 représente un système d'alimentation électrique à découpage,

- la figure 3 représente un variateur de vitesse employant un système d'alimentation électrique à découpage de l'invention,

- la figure 4 représente un dispositif de commande à deux transistors en série, selon l'invention, associé à un convertisseur de type abaisseur de tension,

- les figures 5A à 5C illustrent le principe de fonctionnement du dispositif de commande de l'invention,

- la figure 6 représente un motif pouvant être cascadé plusieurs fois sur le dispositif de commande de l'invention,

- la figure 7 représente un dispositif de commande de l'invention, comprenant plusieurs transistors en cascade.

**Description détaillée d'au moins un mode de réalisation**

Les solutions présentées sur les figures 1A et 1B font partie de l'état de la technique et ont été décrites ci-dessus, dans la partie introductive de la description.

Dans la suite de la description, certains références employées dans la description les figures 1A et 1B sont conservées pour la description de l'invention, dans la mesure où les composants employés sont identiques et remplissent une fonction identique.

L'invention concerne un dispositif de commande 1 destiné à être employé dans un système d'alimentation électrique à découpage. Un tel système d'alimentation électrique à découpage est employé dans un variateur de vitesse, tel que représenté sur la figure 3.

En référence à la figure 3, un variateur de vitesse est alimenté à partir d'un réseau R d'alimentation électrique triphasé délivrant une tension alternative et est basé sur une topologie AC/DC/AC (AC=Courant Alternatif, DC=Courant Continu). Un tel variateur de vitesse comporte ainsi :

- un module redresseur REC destiné à redresser la tension alternative fournie par le réseau,

- un bus continu d'alimentation connecté au module redresseur et comportant une première ligne d'alimentation 10 à potentiel électrique positif et une deuxième ligne d'alimentation 11 à potentiel électrique négatif entre lesquelles est appliquée une tension continue Vbus principale fournie par le module redresseur,

- un condensateur de bus Cbus connecté à la première ligne d'alimentation 10 et à la deuxième ligne d'alimentation 11 et chargé de maintenir la tension continue Vbus à une valeur constante,

- un module onduleur INV comportant plusieurs transistors de commutation destinés à convertir la tension continue disponible sur le bus en une tension variable à destination d'une charge électrique M.

La tension continue Vbus principale est employée pour alimenter le système d'alimentation électrique à découpage. Le système d'alimentation électrique à découpage est notamment employé pour fournir une tension de commande aux transistors du module onduleur INV.

Un système d'alimentation électrique à découpage, tel que représenté sur la figure 2, comporte une première borne X destinée à être connectée à la première ligne d'alimentation 10 et une deuxième borne Y destinée à être connectée à la deuxième ligne d'alimentation 11 du bus continu d'alimentation. Le système comporte un convertisseur continu/continu connecté à sa première borne X et un dispositif de commande 1 connecté en série avec le convertisseur continu/continu et à sa deuxième borne Y. Le convertisseur continu/continu peut se présenter sous la forme de différentes topologies connues, telles que par exemple "flyback" isolé, "forward" isolé, abaisseur ("buck") ou élévateur ("boost"). La figure 2 montre l'association du dispositif de commande de l'invention avec un convertisseur de type "flyback".

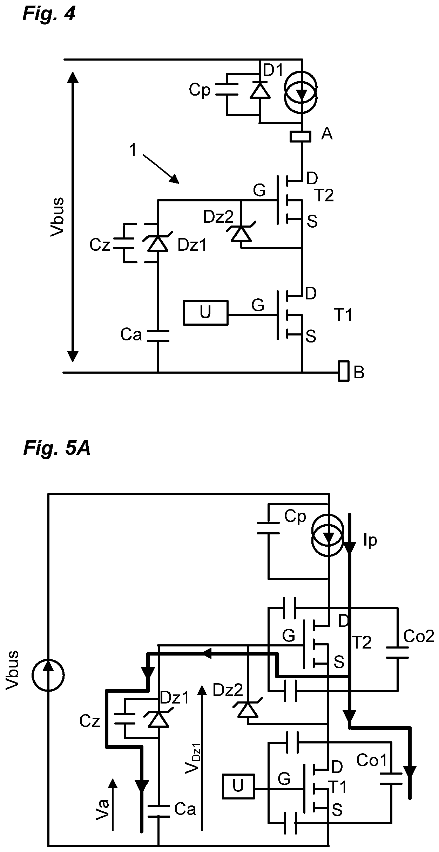

En référence à la figure 4, le dispositif de commande 1 de l'invention, associé à un convertisseur de type abaisseur de tension, comporte deux bornes d'entrée A, B. La première borne d'entrée A est destinée à être connectée au convertisseur abaisseur de tension du système d'alimentation électrique à découpage et la deuxième borne d'entrée B est destinée à être connectée à la deuxième borne Y du système.

Le dispositif de commande 1 comporte deux transistors T1, T2 connectés en série entre sa première borne d'entrée A et sa deuxième borne d'entrée B. Préférentiellement, chacun des transistors est un MOSFET, un IGBT ou un transistor fabriqué dans un matériau à grande énergie de bande interdite ("wide-band gap material") tel que le carbure de silicium ou le nitrure de gallium. Choisir deux transistors en série permet de diviser par deux la tension supportée aux bornes de chacun des transistors, et donc de diminuer leur coût et leur encombrement par rapport à un seul transistor supportant l'intégralité de la tension.

Chaque transistor T1, T2 possède une grille G dont la commande permet de faire passer un courant entre un drain D et une source S. Comme représenté sur la figure 4, la source S du premier transistor T1 est connectée à la deuxième borne d'entrée B, la source S du deuxième transistor T2 est connectée au drain D du premier transistor T1 et le drain du deuxième transistor T2 est connecté à la première borne d'entrée A.

La grille G du premier transistor T1 est connectée à une unité de commande U délivrant des signaux de commande, par exemple de type MLI (Modulation de Largeur d'Impulsion ou PWM pour "Pulse Width Modulation"), pour commander le premier transistor T1 à l'ouverture ou à la fermeture. La grille G du deuxième transistor T2 est à commande flottante. Ainsi, elle est connectée à la deuxième borne d'entrée B à travers un ensemble de commande spécifique, objet de l'invention.

Cet ensemble de commande comporte un condensateur Ca connecté en série à la deuxième borne d'entrée B et un dispositif d'écrêtage/aiguillage, par exemple une diode zener Dz1, connectée au condensateur Ca et à la grille G du deuxième transistor T2. La diode zener Dz1 est connectée en série avec le condensateur Ca.

L'ensemble de commande comporte également une deuxième diode Zener Dz2 connectée entre la grille G et la source S du deuxième transistor T2.

Le condensateur Ca est ainsi autoalimenté par la décharge de la grille G du deuxième transistor T2 et par la charge de la capacité parasite drain-source Co2 du transistor T2. Cette auto-alimentation se produit durant la phase d'ouverture du premier transistor T1. Durant cette phase, la diode Zener Dz1 est clampée et conduit en inverse.

La phase d'ouverture et la phase de fermeture de l'ensemble de commande sont explicitées ci-dessous :

Phase d'ouverture :

Initialement, les deux transistors T1, T2 sont fermés.

Figure 5A : L'unité de commande U envoie un signal d'ouverture sur la grille G du premier transistor T1. La tension Drain-Source $V_{DS1}$ du premier transistor T1 commence à augmenter, entraînant une augmentation de la tension $V_{Dz1}$ aux bornes de la diode Zener Dz1. Le courant Ip (courant primaire du transformateur) circule à travers la grille G du deuxième transistor T2 et charge les capacités parasites, Cz de la diode Zener Dz1, Co1 du premier transistor T1 et la capacité du condensateur Ca et décharge la capacité parasite Cp de la diode D1 du convertisseur. Ce courant Ip permet une augmentation de la tension $V_{Dz1}$ aux bornes de la diode Zener Dz1 et de la tension Va aux bornes du condensateur Ca. Il permet également la décharge de la grille G du deuxième transistor T2. Le deuxième transistor T2 est cependant toujours à l'état passant.

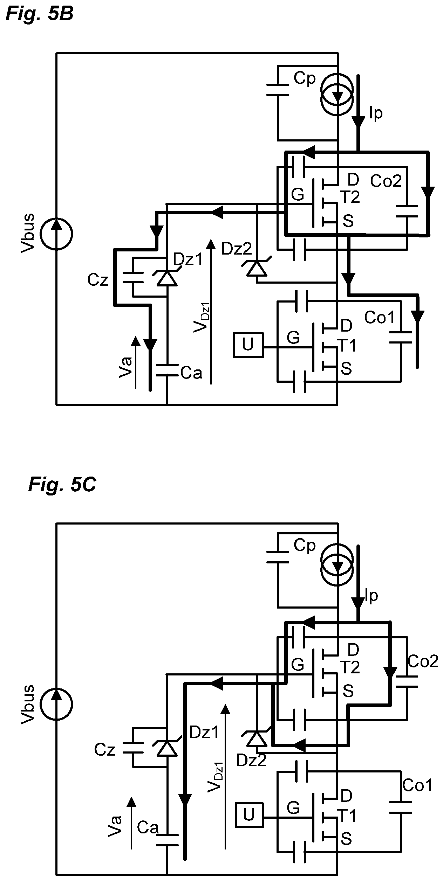

Figure 5B : Dès que la tension Grille-Source $V_{GS2}$ du deuxième transistor T2 passe au-dessous de la tension limite de changement d'état, le deuxième transistor T2 passe à l'état ouvert, entraînant l'augmentation de sa tension Drain-Source $V_{DS2}$. Lorsque le deuxième transistor T2 est à l'état ouvert, le courant Ip charge les capacités parasites Co1, Co2, Cz et continue de décharger la grille du deuxième transistor T2 et la capacité parasite Cp.

Figure 5C : Une fois que la tension Drain-Source du premier transistor T1 $V_{DS1}$ a atteint la tension de clampage de la diode Zener DZ1, la charge du condensateur parasite Co1 du transistor T1 est terminée et le courant $I_{DS1}$ traversant le premier transistor T1 devient nul.

Le courant Ip continue la charge et la décharge des capacités parasites Co2, Cp respectivement du deuxième transistor T2 et de la diode D1 tant que celles-ci ne sont pas entièrement chargées. La diode Zener Dz2 conduit en direct et la diode zener Dz1 conduit en inverse jusqu'à la charge et décharge complète respective des capacités parasites Co2, Cp.

A la fermeture :

Initialement, les deux transistors T1, T2 sont ouverts.

L'unité de commande U envoie un signal de fermeture sur la grille du premier transistor T1. La tension Drain-Source $V_{DS1}$ aux bornes du premier transistor T1 chute jusqu'à la pleine conduction du premier transistor, représentant son état résistif.

La tension Va aux bornes du condensateur Ca est alors suffisante pour piloter correctement le deuxième transistor T2. Cette tension Va auto-adaptative s'exprime de la manière suivante :

$$Va = Vfw_{DZ1} + V_{Dz2} + (Id_{T1} * Rds_{ON\_T1})$$

Dans laquelle :

- Va représente la tension aux bornes du condensateur Ca,
- $Vfw_{Dz1}$ représente la tension de seuil de conduction directe de la diode zener Dz1,
- $V_{Dz2}$ représente la tension clampage de la diode zener Dz2,
- $Id_{T1}$ représente le courant Drain-Source traversant le premier transistor T1,
- $Rds_{ON\_T1}$ représente la résistance à l'état passant du premier transistor T1.

Partant de l'architecture décrite ci-dessus, l'invention consiste également à cascader des transistors au-dessus du deuxième transistor T2.

Pour effectuer cela, il est possible de superposer un ou plusieurs motifs identiques sur l'architecture décrite précédemment et comprenant les deux transistors T1, T2. Le premier motif est connecté à la grille G et au drain D du deuxième transistor T2.

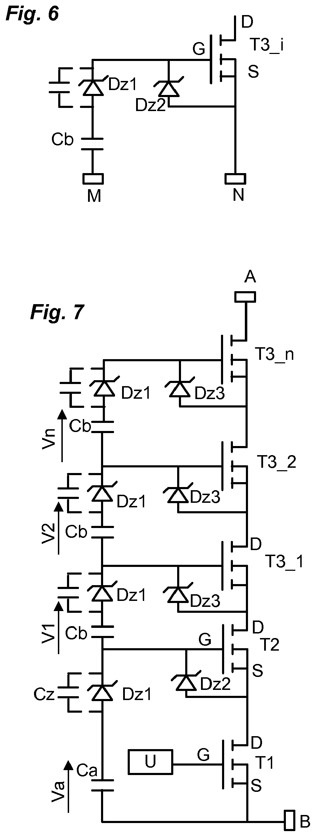

En référence à la figure 6, un motif comporte deux points de connexion M, N. Chaque motif comporte un condensateur Cb, pouvant être identique au condensateur Ca cité précédemment, connecté à un premier point de connexion M, une diode zener Dz1, identique à la précédente pour respecter le partage des tensions, connectée en série avec le condensateur Cb, un transistor T3_i (i=1 à n), du même type que les transistors T1, T2 principaux, dont la grille G est connectée au condensateur Cb, et la source S est connectée à un deuxième point de connexion N. Le motif comporte également une diode zener Dz3 (identique ou non à Dz2) connectée entre la grille G et la source S du transistor T3_i.

Chaque motif ajouté vient se connecter par son deuxième point de connexion N sur le drain D du transistor (T3_n-1) du motif précédent et par son premier point de connexion M sur la grille G du transistor (T3_n-1) du motif précédent.

Le drain D du transistor du dernier motif (T3_n) est connecté à la première borne d'entrée A décrite ci-dessus.

A l'ouverture du premier transistor T1 commandée par l'unité de commande U, les capacités parasites des transistors en cascade se chargent par le courant Ip. La tension aux bornes de chaque transistor T3_i est écrêtée à la tension de sa diode zener Dz1. Les diodes zener conduisent et chargent les condensateurs Cb des motifs.

A la fermeture, la tension aux bornes de chaque condensateur Cb des motifs, compense les chutes de tension. Cette tension V1 aux bornes de chaque condensateur Cb d'un motif s'exprime de la manière suivante :

$$V1 = (V_{Dz3} - V_{Dz2}) + Vfw_{Dz1} + Id_{T2} * Rds_{on\_T2}$$

$$Vn = (V_{Dz3} - V_{Dz2}) + Vfw_{Dz1} + Id_{Tn} * Rds_{on\_Tn}$$

Si VDz3=VDz2, et les résistances à l'état passant des transistors sont identiques ($Rds_{on\_Tn}$), on obtient alors :

$$V1 = V2 = Vn = Vfw_{Dz1} + Id_{T2} * Rds_{on\_Tn}$$

L'emploi d'un condensateur dit "flottant" dans la mise en cascade de plus de deux transistors de type MOSFET permet de compenser les chutes de tension des diodes zener Dz1 associés et la chute de tension liée à la résistance à l'état passant du transistor.

**Revendications**

1. Dispositif de commande (1) destiné à être employé dans un système d'alimentation électrique à découpage pour commander un convertisseur continu/continu dudit système d'alimentation électrique à découpage, ledit dispositif de commande comportant une première borne d'entrée (A) et une deuxième borne d'entrée (B), un premier transistor (T1) connecté par sa source à la deuxième borne d'entrée (B) et doté d'une grille (G) destinée à recevoir des signaux de commande provenant d'une unité de commande (U) et un deuxième transistor (T2) doté d'une grille (G) et connecté par son drain (D) à la première borne d'entrée (A) et par sa source (S) au premier transistor (T1), le dispositif de commande comportant:

   - un ensemble de commande connecté à la grille (G) du deuxième transistor (T2) et à la deuxième borne d'entrée (B) et comprenant un condensateur (Ca) et une diode zener (Dz1) connectée en série avec ledit condensateur (Ca), ledit condensateur (Ca) étant agencé pour compenser les chutes de tension de ladite diode zener (Dz1),
   - une deuxième diode zener (Dz2) connectée entre la grille (G) et la source (S) du deuxième transistor (T2).

2. Dispositif selon la revendication 1, **caractérisé en ce qu'**il comporte un ou plusieurs motifs identiques superposés, chaque motif comprenant :

   - deux points de connexion (M, N),
   - un condensateur (Cb) connecté à un premier point de connexion (M),
   - une première diode zener (Dz1) connectée en série avec ledit condensateur (Cb),
   - un troisième transistor (T3_i) doté d'une grille (G) connectée audit condensateur (Cb) et d'une source (S) connectée à un deuxième point de connexion (N),
   - une troisième diode zener (Dz3) connectée entre la grille (G) et la source (S) du troisième transistor (T3_i),
   - le premier motif ajouté venant se connecter par son deuxième point de connexion (N) sur le drain (D) du deuxième transistor (T2) et par son premier point de connexion (M) sur la grille (G) du deuxième transistor (T2),
   - chaque motif supplémentaire venant se connecter par son deuxième point de connexion (N) sur le drain (D) du transistor (T3_n-1) du motif précédent et par son premier point de connexion (M) sur la grille (G) du transistor (T3_n-1) du motif précédent.

3. Système d'alimentation électrique à découpage comprenant une première borne (X) et une deuxième borne (Y) entre lesquelles est connectée une source de tension continue, un convertisseur continu/continu connecté à la première borne (X) et un dispositif de commande (1) connecté en série avec le convertisseur continu/continu et à la deuxième borne (Y), **caractérisé en ce que** ledit dispositif de commande (1) est conforme à celui défini dans l'une des revendications 1 ou 2.

4. Système selon la revendication 3, **caractérisé en ce que** le convertisseur continu/continu est de type "flyback" isolé.

5. Système selon la revendication 3, **caractérisé en ce que** le convertisseur continu/continu est de type "forward" isolé.

6. Système selon la revendication 3, **caractérisé en ce que** le convertisseur continu/continu est de type élévateur.

7. Système selon la revendication 3, **caractérisé en ce que** le convertisseur continu/continu est de type abaisseur.

8. Variateur de vitesse destiné à commander une charge électrique (M), comportant :

   - un module redresseur (REC) destiné à redresser une tension alternative fournie par un réseau (R) de distribution électrique,
   - un bus continu d'alimentation connecté au module redresseur (REC) et comportant une première ligne d'alimentation (10) à potentiel électrique positif et une deuxième ligne d'alimentation (11) à potentiel électrique négatif entre lesquelles est appliquée une tension continue (Vbus) principale fournie par le module redresseur,
   - un condensateur de bus (Cbus) connecté à la première ligne d'alimentation (10) et à la deuxième ligne d'alimentation (11),
   - un module onduleur (INV) comportant plusieurs transistors de commutation destinés à convertir la tension continue (Vbus) disponible sur le bus en une tension variable à destination de la charge électrique (M),

   **caractérisé en ce qu'**il comporte :

   - un système d'alimentation électrique à découpage conforme à celui défini dans l'une des revendications 3 à 7 et **en ce que** la première borne (X) du système d'alimentation électrique à découpage est connectée à la première ligne d'alimentation (10) du bus continu d'alimentation et la deuxième borne (Y) du système d'alimentation électrique à découpage est connectée à la deuxième ligne d'alimentation (11) du bus continu d'alimentation.

**Patentansprüche**

1. Steuervorrichtung (1), die dazu bestimmt ist, in einem elektrischen Schaltnetzteil-System verwendet zu werden, um einen Gleichstrom/Gleichstrom-Wandler des elektrischen Schaltnetzteil-Systems zu steuern, wobei die Steuervorrichtung eine erste Eingangsklemme (A) und eine zweite Eingangsklemme (B), einen ersten Transistor (T1), der über seine Source mit der zweiten Eingangsklemme (B) verbunden und mit einem Gate (G) versehen ist, das dazu bestimmt ist, von einer Steuereinheit (U) kommende Steuersignale zu empfangen, und einen zweiten Transistor (T2) aufweist, der mit einem Gate (G) versehen und über seinen Drain (D) mit der ersten Eingangsklemme (A) und über seine Source (S) mit dem ersten Transistor (T1) verbunden ist, wobei die Steuervorrichtung aufweist:

   - eine Steuereinheit, die mit dem Gate (G) des zweiten Transistors (T2) und mit der zweiten Eingangsklemme (B) verbunden ist und einen Kondensator (Ca) und eine Zener-Diode (Dz1) enthält, die mit dem Kondensator (Ca) in Reihe geschaltet ist, wobei der Kondensator (Ca) eingerichtet ist, um die Spannungsabfälle der Zener-Diode (Dz1) zu kompensieren,
   - eine zweite Zener-Diode (Dz2), die zwischen dem Gate (G) und der Source (S) des zweiten Transistors (T2) angeschlossen ist.

2. Vorrichtung nach Anspruch 1, **dadurch gekennzeichnet, dass** sie eines oder mehrere übereinanderliegende gleiche Muster aufweist, wobei jedes Muster enthält:

   - zwei Anschlusspunkte (M, N),
   - einen Kondensator (Cb), der an einen ersten Anschlusspunkt (M) angeschossen ist,
   - eine erste Zener-Diode (Dz1), die mit dem Kondensator (Cb) in Reihe geschaltet ist,
   - einen dritten Transistor (T3_i), der mit einem an den Kondensator (Cb) angeschlossenen Gate (G) und mit einer an einen zweiten Anschlusspunkt (N) angeschlossenen Source (S) versehen ist,
   - eine dritte Zener-Diode (Dz3), die zwischen dem Gate (G) und der Source (S) des drittem Transistors (T3_i) angeschlossen ist,
   - wobei das erste hinzugefügte Muster über seinen zweiten Anschlusspunkt (N) an den Drain (D) des zweiten Transistors (T2) und über seinen ersten Anschlusspunkt (M) an das Gate (G) des zweiten Transistors (T2) angeschlossen ist,
   - wobei jedes zusätzliche Muster über seinen zweiten Anschlusspunkt (N) an den Drain (D) des Transistors (T3_n-1) des vorhergehenden Musters und über seinen ersten Anschlusspunkt (M) an das Gate (G) des Transistors (T3_n-1) des vorhergehenden Musters angeschlossen ist.

3. Elektrisches Schaltnetzteil-System, das eine erste Klemme (X) und eine zweite Klemme (Y), zwischen denen eine Gleichstromquelle angeschlossen ist, einen an die erste Klemme (X) angeschlossenen Gleichstrom/Gleichstrom-Wandler und eine Steuervorrichtung (1) enthält, die mit dem Gleichstrom/Gleichstrom-Wandler und mit der zweiten Klemme (Y) in Reihe geschaltet ist, **dadurch gekennzeichnet, dass** die Steuervorrichtung (1) gleich der in einem der Ansprüche 1 oder 2 definierten ist.

4. System nach Anspruch 3, **dadurch gekennzeichnet, dass** der Gleichstrom/Gleichstrom-Wandler von der Art isolierter Sperrwandler ist.

5. System nach Anspruch 3, **dadurch gekennzeichnet, dass** der Gleichstrom/Gleichstrom-Wandler von der Art isolierter Durchflusswandler ist.

6. System nach Anspruch 3, **dadurch gekennzeichnet, dass** der Gleichstrom/Gleichstrom-Wandler von der Art Aufwärtswandler ist.

7. System nach Anspruch 3, **dadurch gekennzeichnet, dass** der Gleichstrom/Gleichstrom-Wandler von der Art Abwärtswandler ist.

8. Umrichter, der dazu bestimmt ist, eine elektrische Last (M) zu steuern, der aufweist:

   - ein Gleichrichtermodul (REC), das dazu bestimmt ist, eine von einem elektrischen Verteilernetz (R) gelieferte Wechselspannung gleichzurichten,
   - einen Gleichstromversorgungsbus, der an das Gleichrichtermodul (REC) angeschlossen ist und eine erste Versorgungsleitung (10) mit positivem elektrischem Potential und eine zweite Versorgungsleitung (11) mit negativem elektrischem Potential aufweist, zwischen denen eine vom Gleichrichtermodul gelieferte Hauptgleichspannung (Vbus) angelegt wird,
   - einen Buskondensator (Cbus), der an die erste Versorgungsleitung (10) und an die zweite Versorgungsleitung (11) angeschlossen ist,
   - ein Wechselrichtermodul (INV), das mehrere Schalttransistoren aufweist, die dazu bestimmt sind, die auf dem Bus verfügbare Gleichspannung (Vbus) in eine für die elektrische Last (M) bestimmte variable Spannung umzuwandeln, **dadurch gekennzeichnet, dass** er aufweist:

- ein elektrisches Schaltnetzteil-System entsprechend demjenigen, das in einem der Ansprüche 3 bis 7 definiert ist, und dass die erste Klemme (X) des elektrischen Schaltnetzteil-Systems an die erste Versorgungsleitung (10) des Gleichstromversorgungsbusses angeschlossen und die zweite Klemme (Y) des elektrischen Schaltnetzteil-Systems an die zweite Versorgungsleitung (11) des Gleichstromversorgungsbusses angeschlossen ist.

## Claims

1. Control device (1) intended to be employed in a switched electrical power supply system to control a DC/DC converter of said switched electrical power supply system, said control device comprising a first input terminal (A) and a second input terminal (B), a first transistor (T1) connected via its source to the second input terminal (B) and furnished with a gate (G) intended to receive control signals originating from a control unit (U) and a second transistor (T2) provided with a gate (G) and connected via its drain (D) to the first input terminal (A), and via its source (S) to the first transistor (T1), the control device including:

   - a control assembly connected to the gate (G) of the second transistor (T2) and to the second input terminal (B) and including a capacitor (Ca) and a Zener diode (Dz1) connected in series to said capacitor (Ca), said capacitor (Ca) being arranged to compensate the voltage drops of said Zener diodes (Dz1),
   - a second Zener diode (Dz2) connected between the gate (G) and the source (S) of the second transistor (T2).

2. Device according to Claim 1, **characterized in that** it comprises one or more superimposed identical patterns, each pattern comprising:

   - two connection points (M, N),
   - a capacitor (Cb) connected to a first connection point (M),
   - a first Zener diode (Dz1) connected in series with said capacitor (Cb),
   - a third transistor (T3_i) furnished with a gate (G) connected to said capacitor (Cb) and with a source (S) connected to a second connection point (N),
   - a third Zener diode (Dz3) connected between the gate (G) and the source (S) of the third transistor (T3_i),

   - the first added pattern being connected up by its second connection point (N) to the drain (D) of the second transistor (T2) and by its first connection point (M) to the gate (G) of the second transistor (T2),
   - each additional pattern being connected up by its second connection point (N) to the drain (D) of the transistor (T3_n-1) of the previous pattern and by its first connection point (M) to the gate (G) of the transistor (T3_n-1) of the previous pattern.

3. Switched electrical power supply system comprising a first terminal (X) and a second terminal (Y) between which is connected a DC voltage source, a DC/DC converter connected to the first terminal (X) and a control device (1) connected in series with the DC/DC converter and to the second terminal (Y), **characterized in that** said control device (1) is in accordance with that defined in one of Claims 1 or 2.

4. System according to Claim 3, **characterized in that** the DC/DC converter is of insulated "flyback" type.

5. System according to Claim 3, **characterized in that** the DC/DC converter is of insulated "forward" type.

6. System according to Claim 3, **characterized in that** the DC/DC converter is of step-up type.

7. System according to Claim 3, **characterized in that** the DC/DC converter is of step-down type.

8. Variable speed drive intended to control an electrical load (M), comprising:

   - a rectifier module (REC) intended to rectify an AC voltage provided by an electrical distribution network (R),
   - a DC power supply bus connected to the rectifier module (REC) and comprising a first power supply line (10) at positive electrical potential and a second power supply line (11) at negative electrical potential between which is applied a main DC voltage (Vbus) provided by the rectifier module,
   - a bus capacitor (Cbus) connected to the first power supply line (10) and to the second power supply line (11),
   - an inverter module (INV) comprising several switching transistors intended to convert the DC voltage (Vbus) available on the bus into a variable voltage destined for the electrical load (M),

   **characterized in that** it comprises:

   - a switched electrical power supply system in accordance with that defined in one of Claims 3 to 7 and **in that** the first terminal (X) of the switched electrical power supply system is connected to the first power supply line (10) of the DC power supply bus and the second terminal (Y) of the switched electrical power supply system is connected to the second power supply line (11) of the DC power supply bus.

**Fig. 1A**

**Fig. 1B**

**Fig. 2**

**Fig. 3**

*Fig. 4*

*Fig. 5A*

**Fig. 5B**

**Fig. 5C**

**Fig. 6**

**Fig. 7**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0453376 A2
- EP 0140349 A2
- US 20110261594 A1

**Littérature non-brevet citée dans la description**

- **ROBERT L. HESS ; RUSSEL JACOB BAKER.** Transformerless Capacitive Coupling of Gate Signals for Series Operation of Power MOS Devices. *IEEE transactions on power electronics,* Septembre 2000, vol. 15 (5
- **HERBERT L HESS.** *Transformerless Capacitive coupling of Gate Signais for Series Operation of Power MOS Devices,* 01 Septembre 2000